# EUROPEAN PATENT SPECIFICATION

(11) **EP 3 929 534 B1**
(45) Date of publication and mention of the grant of the patent: **31.05.2023**
(21) Application number: 21181380.3
(22) Date of filing: 24.06.2021
(51) Int. Cl.: G01C 15/00, G01S 17/42, G01S 17/89, G01S 7/51

(54) **EYEWEAR DISPLAY SYSTEM AND EYEWEAR DISPLAY METHOD**
BRILLENANZEIGESYSTEM UND BRILLENANZEIGEVERFAHREN
SYSTÈME ET PROCÉDÉ D'AFFICHAGE DE LUNETTES

(30) Priority: 25.06.2020 JP 2020109966
(43) Date of publication of application: 29.12.2021
(73) Proprietor: TOPCON CORPORATION, Tokyo 174-8580 (JP)
(72) Inventor: YASUTOMI, Satoshi, Tokyo, 174-8580 (JP); KIKUCHI, Takeshi, Tokyo, 174-8580 (JP)
(74) Representative: dompatent von Kreisler Selting Werner - Partnerschaft von Patent- und Rechtsanwälten mbB

(56) References cited:
- WO-A1-2019/048866
- JP-A- 2003 337 023
- JP-A- 2006 133 171
- US-A1- 2019 094 021

## Description

### TECHNICAL FIELD

The present invention relates to an eyewear display system, and more specifically to an eyewear display system for assisting point cloud data observation using a ground-mounted scanner.

### BACKGROUND

Conventionally, point cloud data observation using a ground-mounted scanner has been known (for example, refer to Patent Literature 1). In point cloud data observation, point cloud density must be secured to meet required observation accuracy. The point cloud density depends on a measurement distance from the scanner and a rotation speed of the scanner. That is, in a region at a short distance from the scanner, the point cloud density is high, but the point cloud density becomes lower with increasing distance from the scanner.

Although the point cloud density is high when the rotation speed of the scanner is low, the point cloud density is low when the rotation speed is high. Therefore, in order to secure required point cloud density, by setting a plurality of scanner installation points (instrument installation points) so that measurement regions overlap to some degree, point cloud data is acquired.

Therefore, in point cloud observation, measurements are made by setting scanner installation points (instrument installation points) in order so that measurement regions overlap.
An eyewear display device having the features defined within the preamble of claim 1 is known from Patent Literature 2.

### CITATION LIST

### Patent Literature

Patent Literature 1 Japanese Published Unexamined Patent Application No. 2018-28464
Patent Literature 2 U.S. Patent Application US 2019/094021 A1

### SUMMARY OF INVENTION

### Technical Problem

However, an excessive amount of effort is required to install a scanner at the next instrument installation points in order and perform observation while being aware of this overlapping on-site. In addition, there is a risk of omission in measurement results.

The present invention has been made in view of these circumstances, and an object thereof is to provide a technology for facilitating on-site observation without omission in point cloud data observation using a ground-mounted scanner.

### Solution to Problem

In order to achieve the object described above, a point cloud data observation system according to one aspect of the present invention includes a scanner including a measuring unit configured to irradiate pulsed distance-measuring light and acquire three-dimensional coordinates of an irradiation point by measuring a distance and an angle to the irradiation point, and a point cloud data acquiring unit configured to acquire point cloud data as observation data by rotationally irradiating distance-measuring light in the vertical direction and the horizontal direction by the measuring unit; an eyewear device including a display, a relative position detection sensor configured to detect a position of the device, and a relative direction detection sensor configured to detect a direction of the device; a storage device configured to store an observation route calculated in consideration of three-dimensional CAD design data of an observation site and instrument information of the scanner; and an information processing device including a coordinate synchronizing unit configured to synchronize information on a position and a direction of the eyewear device and a coordinate space of the observation route, and an eyewear display control unit configured to control display of the observation route on the display, wherein the scanner, the eyewear device, the storage device, and the information processing device are capable of inputting and outputting information to each other, and the eyewear device superimposes and displays the observation route on a landscape of the site.

In the aspect described above, it is also preferable that the observation route is calculated to enable acquisition of point cloud data at required point cloud density by a minimum number of instrument installation points in the entire observation site in consideration of the instrument information of the scanner and a three-dimensional structure in the three-dimensional CAD design data, and the instrument information of the scanner includes coordinates of an instrument center of the scanner, pulse interval setting of the distance-measuring light, and rotation speed setting of the scanner.

In the aspect described above, it is also preferable that the observation route is calculated to be a shortest route connecting all instrument installation points in the observation site.

In the aspect described above, it is also preferable that the eyewear device is configured to update display of the observation route according to observation progress information.

In the aspect described above, it is also preferable that the information processing device is configured to recalculate the order of the instrument installation points in the observation route when point cloud observation by the scanner deviates from the observation route.

### Benefit of Invention

By the eyewear display system according to the aspect described above, in point cloud data observation using a ground-mounted scanner, observation without omission can be easily performed.

### BRIEF DESCRIPTION OF DRAWINGS

FIG. 1 is an external perspective view of an eyewear display system according to an embodiment of the present invention.
FIG. 2 is a configuration block diagram of the eyewear display system according to the same embodiment.
FIG. 3 is a configuration block diagram of a scanner in the same display system.
FIG. 4 is an external perspective view of an eyewear device in the same display system.
FIG. 5 is a configuration block diagram of the same eyewear device.
FIG. 6 is a configuration block diagram of a processing PC according to the same embodiment.
FIG. 7 is a view illustrating an image of point cloud data that the scanner of the same display system can acquire.
FIGS. 8A to 8C are diagrams describing a method for calculating an observation route to be used in the same display system.
FIGS. 9A and B are diagrams describing a method for calculating an observation route to be used in the same display system.
FIG. 10 is a flowchart of a point cloud observation method using the display system described above.
FIG. 11 is a diagram describing initial settings in the same point cloud observation method.
FIG. 12 is a diagram describing a method for calculating an observation route to be used in a display system according to a modification of the embodiment.
FIG. 13 is a configuration block diagram of a processing PC of a display system according to another modification of the embodiment.
FIG. 14 is a flowchart of a point cloud observation method using the display system according to the same modification.
FIG. 15 is a configuration block diagram of a processing PC of a display system according to still another modification of the embodiment.

### DESCRIPTION OF EMBODIMENT

Hereinafter, a preferred embodiment of the present invention will be described with reference to the drawings, however, the present invention is not limited to this embodiment. The same components common to the embodiment and respective modifications are provided with the same reference signs, and overlapping descriptions are omitted as appropriate.

### Embodiment

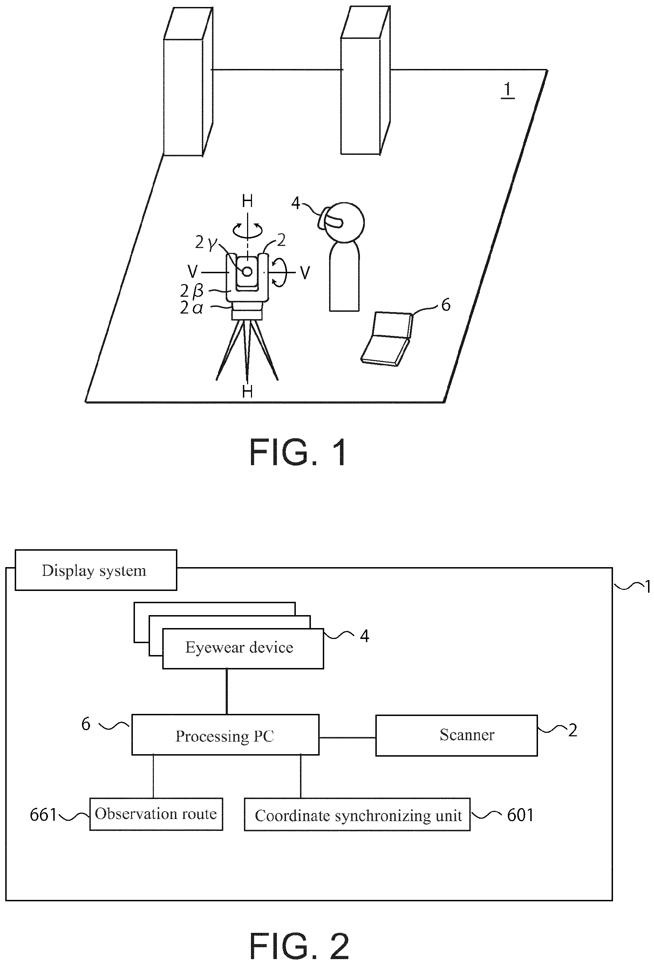

FIG. 1 is an external perspective view of an eyewear display system (hereinafter, also simply referred to as "display system") according to an embodiment of the present invention, and illustrates a work image at a measurement site. The display system 1 according to the present embodiment includes a scanner 2, an eyewear device 4, and a processing PC 6.

The scanner 2 is installed at an arbitrary point via a leveling base mounted on a tripod. The scanner 2 includes a base portion 2α provided on the leveling base, a bracket portion 2β that rotates horizontally about an axis H-H on the base portion 2α, and a light projecting portion 2γ that rotates vertically at the center of the bracket portion 2β. The eyewear device 4 is worn on the head of a worker. The processing PC 6 is installed at an observation site.

FIG. 2 is a configuration block diagram of the display system 1. In the display system 1, the scanner 2 and the eyewear device 4 are connected to the processing PC 6 wirelessly or by wire. The number of eyewear devices 4 is not particularly limited, and may be one or plural in number. When the number of eyewear devices 4 is plural in number, each eyewear device 4 is configured so as to be identified by its unique ID, etc.

### Scanner

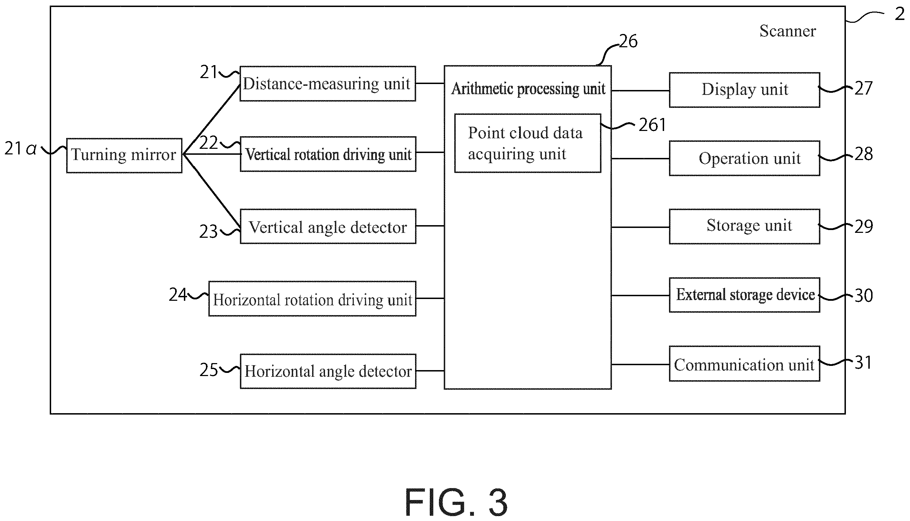

FIG. 3 is a configuration block diagram of the scanner 2 according to this embodiment. The scanner 2 includes a distance-measuring unit 21, a vertical rotation driving unit 22, a vertical angle detector 23, a horizontal rotation driving unit 24, a horizontal angle detector 25, an arithmetic processing unit 26, a display unit 27, an operation unit 28, a storage unit 29, an external storage device 30, and a communication unit 31. In the present embodiment, the distance-measuring unit 21, the vertical angle detector 23, and the horizontal angle detector 25 constitute the measuring unit.

The distance-measuring unit 21 includes a light transmitting unit, a light receiving unit, a light transmitting optical system, a light receiving optical system sharing optical elements with the light transmitting optical system, and a turning mirror 21α. The light transmitting unit includes a light emitting element such as a semiconductor laser, and emits pulsed light as distance-measuring light. The emitted distance-measuring light enters the turning mirror 21α through the light transmitting optical system, and is deflected by the turning mirror 21α and irradiated onto a measuring object. The turning mirror 21α rotates about a rotation axis V-V by being driven by the vertical rotation driving unit 22.

The distance-measuring light retroreflected by the measuring object enters the light receiving unit through the turning mirror 21α and the light receiving optical system. The light receiving unit includes a light receiving element such as a photodiode. A part of the distance-measuring light enters the light receiving unit as internal reference light, and based on the reflected distance-measuring light and internal reference light, a distance to an irradiation point is obtained by the arithmetic processing unit 26.

The vertical rotation driving unit 22 and the horizontal rotation driving unit 24 are motors, and are controlled by the arithmetic processing unit 26. The vertical rotation driving unit 22 rotates the turning mirror 21α about the axis V-V in the vertical direction. The horizontal rotation driving unit 24 rotates the bracket portion 2β about the axis H-H in the horizontal direction.

The vertical angle detector 23 and the horizontal angle detector 25 are encoders. The vertical angle detector 23 measures a rotation angle of the turning mirror 21α in the vertical direction. The horizontal angle detector 25 measures a rotation angle of the bracket portion 2β in the horizontal direction. As a result, the vertical angle detector 23 and the horizontal angle detector 25 constitute an angle-measuring unit that measures an angle of an irradiation direction of the distance-measuring light.

The arithmetic processing unit 26 is a microcontroller configured by mounting, for example, a CPU (Central Processing Unit), a ROM (Read Only Memory), a RAM (Random Access Memory), etc., on an integrated circuit.

The arithmetic processing unit 26 calculates a distance to an irradiation point of each one-pulse light of the distance-measuring light based on a time difference between a light emission timing of the light transmitting unit and a light receiving timing of the light receiving unit (a reflection time of the pulsed light). In addition, the arithmetic processing unit 26 calculates an irradiation angle of the distance-measuring light at this time, and calculates an angle of the irradiation point.

The arithmetic processing unit 26 includes a point cloud data acquiring unit 261 configured by software. By scanning the entire circumference (360°) with distance-measuring light by controlling the distance-measuring unit 21, the vertical rotation driving unit 22, and the horizontal rotation driving unit 24, the point cloud data acquiring unit 261 acquires three-dimensional coordinates of each irradiation point, and acquires point cloud data of the entire circumference as observation data at an instrument installation point. Observation of the point cloud data of the instrument entire circumference of the scanner 2 in this way is referred to as full dome scanning.

The display unit 27 is, for example, a liquid crystal display. The operation unit 28 includes a power key, numeric keys, a decimal key, plus/minus keys, an enter key, and a scroll key, etc., and is configured to enable a worker to operate the scanner 2 and input information into the scanner 2.

The storage unit 29 is, for example, a hard disk drive, and stores programs for executing functions of the arithmetic processing unit 26.

The external storage device 30 is, for example, a memory card, etc., and stores various data acquired by the scanner 2.

The communication unit 31 enables communication with an external network, and for example, connects to the Internet by using an Internet protocol (TCP/IP) and transmits and receives information to and from the eyewear device 4 and the processing PC 6.

### Eyewear Device

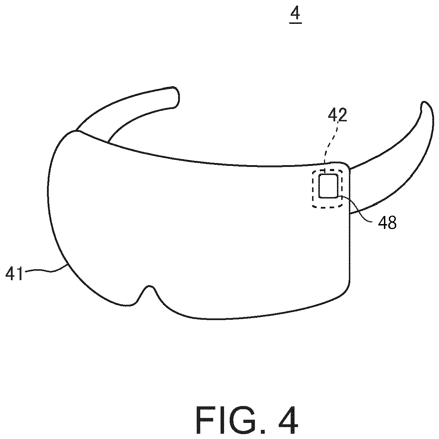

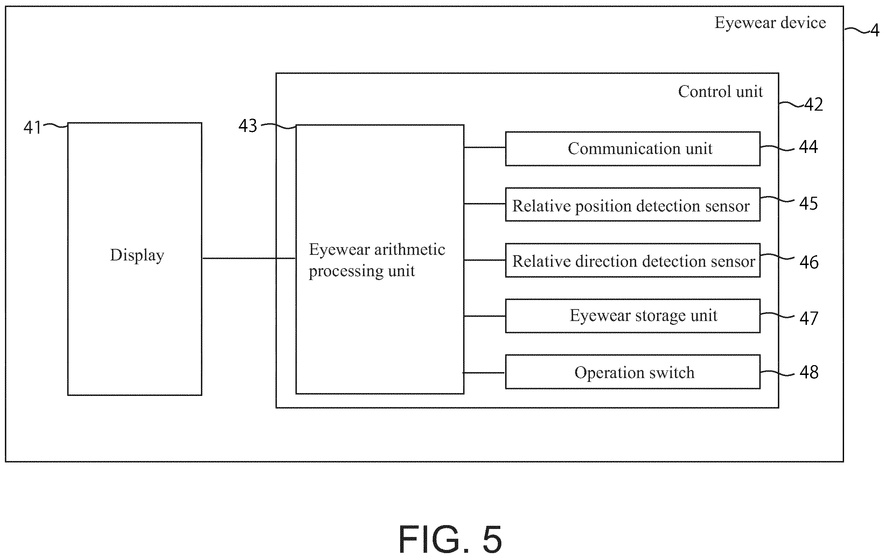

FIG. 4 is an external perspective view of the eyewear device 4 according to the present embodiment, and FIG. 5 is a configuration block diagram of the eyewear device 4. The eyewear device 4 is a wearable device to be worn on the head of a worker. The eyewear device 4 includes a display 41 and a control unit 42.

The display 41 is a goggles-lens-shaped transmissive display that covers the eyes or an eye of a worker when the worker wears it. As an example, the display 41 is an optical see-through display using a half mirror, and is configured to enable observation of a video image obtained by superimposing and synthesizing a virtual image received by the control unit 42 on a real image of a landscape of the site (hereinafter, referred to as "actual landscape").

The control unit 42 includes an eyewear arithmetic processing unit 3, a communication unit 44, a relative position detection sensor (hereinafter, simply referred to as "relative position sensor") 45, a relative direction detection sensor (hereinafter, simply referred to as "relative direction sensor") 46, an eyewear storage unit 47, and an operation switch 48.

The eyewear arithmetic processing unit 43 is a microcomputer configured by mounting at least a CPU and a memory (RAM, ROM) on an integrated circuit. The eyewear arithmetic processing unit 43 outputs information on a position and a direction of the eyewear device 4 detected by the relative position sensor 45 and the relative direction sensor 46 to the processing PC 6.

In addition, the eyewear arithmetic processing unit 43 superimposes and displays an observation route 661 described later as a virtual image on a landscape of the site on the display 41 according to control of the eyewear display control unit 602. In the present embodiment, three-dimensional CAD design data is a three-dimensional design drawing of the observation site, created with an absolute coordinate system by using CAD.

The communication unit 44 enables communication with an external network, and connects to the Internet by using an Internet protocol (TCP/IP) and transmits and receives information to and from the processing PC 6.

The relative position sensor 45 performs wireless positioning from a GPS antenna, a Wi-Fi (registered trademark) access point, and an ultrasonic oscillator, etc., installed at the observation site, to detect a position of the eyewear device 4 in the observation site.

The relative direction sensor 46 consists of a combination of a triaxial accelerometer or a gyro sensor and a tilt sensor. The relative direction sensor 46 detects a tilt of the eyewear device 4 by setting the up-down direction as a Z-axis direction, the left-right direction as a Y-axis direction, and the front-rear direction as an X-axis direction.

The eyewear storage unit 47 is, for example, a memory card. The eyewear storage unit 47 stores programs that enable the eyewear arithmetic processing unit 43 to execute functions.

The operation switch 48 includes, for example, a power button 48α for turning ON/OFF a power supply of the eyewear device 4 as illustrated in FIG. 4.

### Processing PC

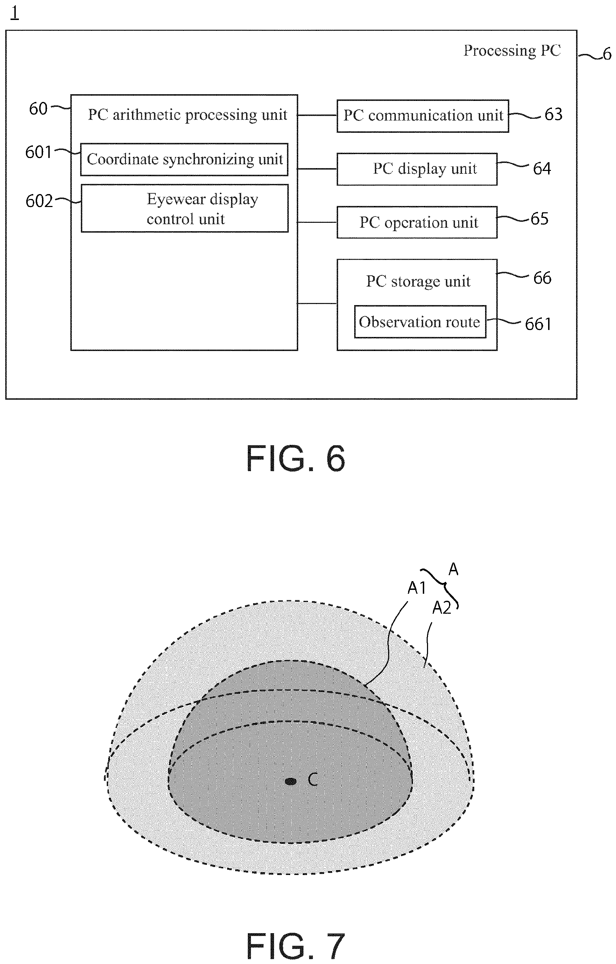

FIG. 6 is a configuration block diagram of the processing PC 6 according to the present embodiment. The processing PC 6 is a general-purpose personal computer, a dedicated hardware using a PLD (Programmable Logic Device), etc., a tablet terminal, or a smartphone, etc. The processing PC 6 includes at least a PC arithmetic processing unit 60, a PC communication unit 63, a PC display unit 64, a PC operation unit 65, and a PC storage unit 66. In the present embodiment, the PC arithmetic processing unit 60 serves as the information processing device, and the PC storage unit 66 serves as the storage device.

The PC communication unit 63 is a communication control device such as a network adapter, a network interface card, a LAN card, a modem, etc., and is a device for connecting the processing PC 6 to the Internet and a communication network such as a WAN, LAN, etc., by wire or wirelessly. The PC arithmetic processing unit 60 transmits and receives (inputs and outputs) information to and from the scanner 2 and the eyewear device 4 through the PC communication unit 63.

The PC display unit 64 is, for example, a liquid crystal display. The PC operation unit 65 is, for example, a keyboard, a mouse, etc., and enables various inputs, selections, and determinations, etc.

The PC storage unit 66 is a computer readable recoding medium that stores, describes, saves, and transmits information in a computer-processable form. For example, a magnetic disc such as an HDD (Hard Disc Drive), an optical disc such as a DVD (Digital Versatile Disc), and a semiconductor memory such as a flash memory are applicable as the PC storage unit 66. The PC storage unit 66 stores at least an observation route 661 calculated in advance in the observation site by the scanner 2.

The PC arithmetic processing unit 60 is a control unit configured by mounting at least a CPU and a memory (RAM, ROM, etc.) on an integrated circuit. In the PC arithmetic processing unit 60, a coordinate synchronizing unit 601 and an eyewear display control unit 602 are configured software-wise by installing a program.

The coordinate synchronizing unit 601 receives information on a position and a direction of the scanner 2 and information on a position and a direction of the eyewear device 4, and manages a coordinate space of the scanner 2, a coordinate space of the eyewear device 4, and a coordinate space of the observation route 661 by converting these into data in the same coordinate space. Such converted observation route 661 is referred to as an observation route 661a.

The eyewear display control unit 602 transmits the observation route 661a converted so as to conform to the coordinate spaces of the eyewear device 4 and the scanner 2 by the coordinate synchronizing unit 601 to the eyewear device 4, and controls display of the observation route 661a on the display 41.

In other words, the PC storage unit 66 stores programs and data for executing the processing of the PC arithmetic processing unit 60 including the coordinate synchronizing unit 601 and the eyewear display control unit 602. The PC arithmetic processing unit 60 can read and execute those programs and data to execute the method of this embodiment. The PC arithmetic processing unit 60 can read and execute those programs and data to execute the method according to this embodiment. In addition, all or part of the method of the present embodiment may be realized by any hardware (processor, storage device, input/output device, etc.), software, or a combination thereof.

### Calculation of Observation Route

Here, the observation route 661 is described. The observation route 661 is calculated in advance by an information processing device such as a personal computer based on instrument information (coordinates of the instrument center, pulse interval setting, and rotation speed setting of scanning) of the scanner 2 and three-dimensional CAD design data of the observation site, and is stored in the PC storage unit 66.

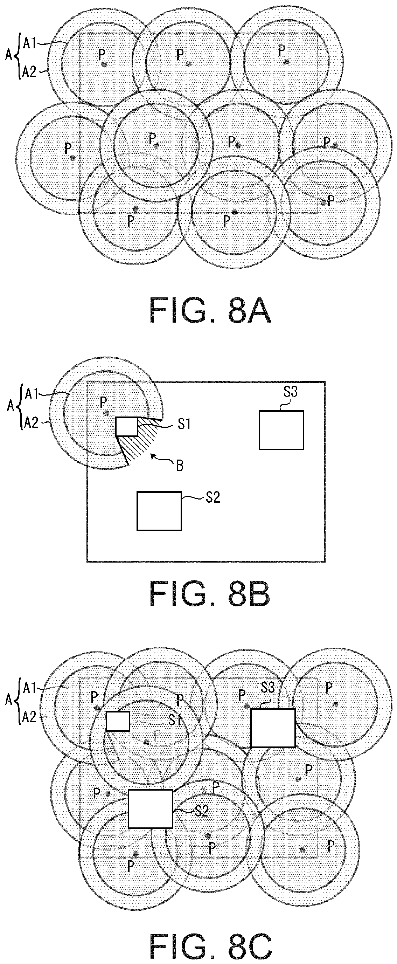

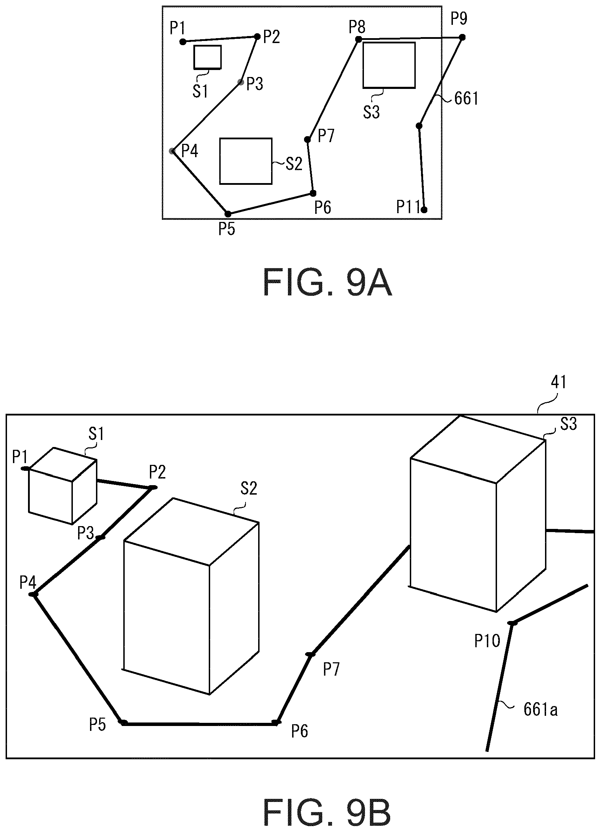

A method for calculating the observation route 661 is described with reference to FIGS. 7 to 9. FIG. 7 three-dimensionally illustrates an image of a point data acquirable region A by the scanner 2. FIG. 8 is a plan view schematically illustrating instrument installation point setting for observation route calculation. FIG. 9A illustrates an example of the calculated observation route 661, and FIG. 9B illustrates an example of display of the observation route 661 on the display 41.

The scanner 2 acquires point cloud data by performing rotational scanning (full dome scanning) with distance-measuring light by a predetermined angle (for example, 360°) in the vertical direction and a predetermined angle (for example, 180°) in the horizontal direction from the instrument center. Therefore, as illustrated in FIG. 7, the point cloud data acquirable region A is a semispherical region A centered at the instrument center C of the scanner 2. For convenience of drawing, the instrument center C is illustrated as being on the ground surface, but in actuality it is positioned higher by an instrument height of the scanner 2 than the ground surface.

Point cloud density acquired by the scanner 2 becomes higher as the pulse interval of the distance-measuring light becomes narrower, becomes lower as the rotation speed of the scanner 2 becomes higher, and becomes lower with increasing distance from the instrument center of the scanner 2. In this way, the point cloud density depends on the pulse interval setting of the distance-measuring light of the scanner 2, rotation speed setting of the scanner 2, and a distance from the instrument center of the scanner.

In the point cloud data observation, according to the purpose of observation and a request from a client, required point cloud density is set. An observation range of the scanner 2 includes a region A1 in which the required point cloud density can be met by one measurement, and a region A2 in which the required point cloud density cannot be met by one measurement, but can be met by overlapping with measurements from other points. Therefore, when designing the observation route, for example, as illustrated in FIG. 8A, it is necessary to set instrument installation points P so that the required point cloud density is met in the entire observation site.

However, point cloud data observation is a survey for acquiring three-dimensional data of three-dimensional structures in an observation site, so that three-dimensional structures (for example, three-dimensional structures S1, S2, and S3 in FIGS. 8A to 8C) are present in the observation site. When three-dimensional structures are present, for example, as illustrated in FIG. 8B, distance-measuring light from the scanner 2 installed at the instrument installation point P irradiated onto (reflected by) the three-dimensional structure S1 does not reach a portion B at the opposite side of the scanner 2 with respect to the three-dimensional structure. So, point cloud data cannot be acquired from the portion. The same occurs three-dimensionally.

Therefore, by using three-dimensional CAD data of the observation site, by performing a computer simulation in three-dimensional consideration of pulse interval setting of the distance-measuring light of the scanner 2, rotation speed setting of the scanner 2, a distance from the instrument center of the scanner, and a positional relationship with the three-dimensional structures, positions of the fewest instrument installation points P which can cover the entire observation range at the required point cloud density are calculated as illustrated in FIG. 8C. That is, point cloud data acquirable regions are calculated by excluding portions on the opposite sides of the scanner with respect to the three-dimensional structures from a point cloud data acquirable region of the scanner, and are overlapped with each other, and accordingly, positions of the minimum number of instrument installation points P covering the entire observation site while meeting the required point cloud density are calculated.

Further, as illustrated in FIG. 9A, a shortest route unicursally connecting the calculated instrument installation points P is calculated. Accordingly, a shortest observation route 661 connecting the instrument installation points arranged so as to cover the entire observation site at the required point cloud density is calculated.

As described above, the observation route 661 is converted into a coordinate system of a coordinate space with an origin set at a reference point by the coordinate synchronizing unit 601, and transmitted to the eyewear device 4 by the eyewear display control unit 602, and for example, as illustrated in FIG. 9B, displayed on the display 41. The instrument installation points P (P1 to P11) are displayed as points on the ground surface of the landscape of the site.

### Point Cloud Observation Method Using Display System 1

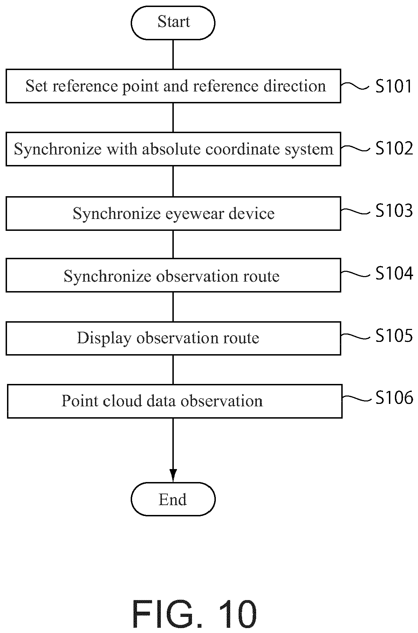

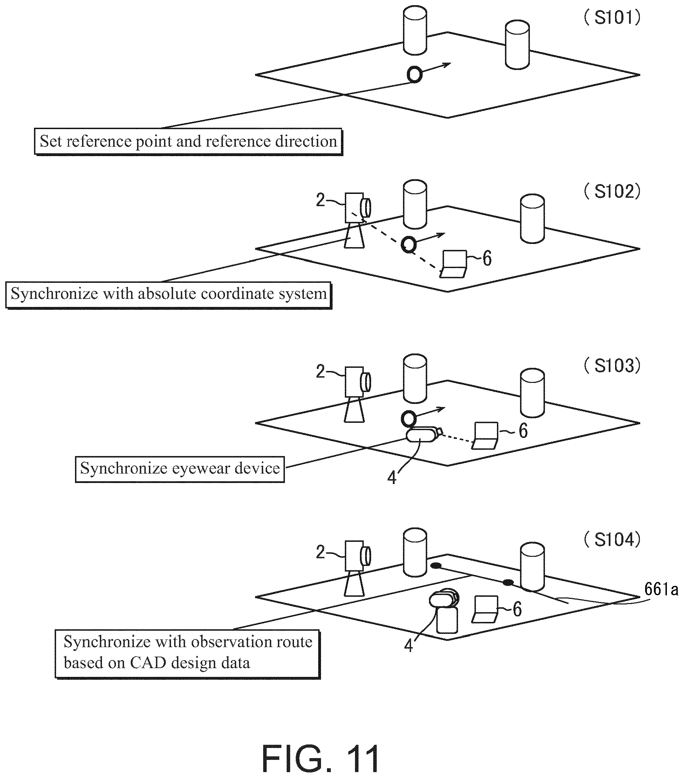

Next, an example of a point cloud observation method using the display system 1 will be described. FIG. 10 is a flowchart of this point cloud observation method. FIG. 11 is a work image view of Steps S101 to S104.

First, in Step S101, a worker sets a reference point and a reference direction in the observation site. Specifically, known points and arbitrary points in the site are selected, and a position of the eyewear device 4 in a state where the worker stands while wearing the eyewear device is set as the reference point. In addition, in the site, a characteristic point (for example, a corner of the structure) different from the reference point is arbitrarily selected, and a direction from the reference point to the characteristic point is defined as the reference direction.

Next, in Step S102, by using the scanner 2, the reference point and the reference direction are synchronized with an absolute coordinate system. Specifically, the worker installs the scanner 2 at an arbitrary point in the site and grasps absolute coordinates of the scanner 2 by using a publicly known method such as backward intersection, and grasps absolute coordinates of the reference point and the characteristic point selected in Step S101. The scanner 2 transmits the acquired absolute coordinates of the scanner 2, the reference point, and the characteristic point to the processing PC 6.

The coordinate synchronizing unit 601 of the processing PC 6 converts the absolute coordinates of the reference point into (x, y, z) = (0, 0, 0), and recognizes the reference direction as a horizontal angle of 0°, and thereafter, enables management of information from the scanner 2 in a space with an origin set at the reference point.

Next, in Step S103, the worker synchronizes the eyewear device 4. Specifically, in a state where the worker stands at the reference point and faces the reference direction while wearing the eyewear device, the worker installs the eyewear device 4 at the reference point, matches the center of the display 41 with the reference direction, and sets (x, y, z) of the relative position sensor 45 to (0, 0, 0) and sets (roll, pitch, yaw) of the relative direction sensor 4 to (0, 0, 0).

Synchronization of the eyewear device 4 is not limited to the method described above, and may be performed by, for example, a method in which the eyewear device 4 is provided with a laser device for indicating the center and the directional axis of the eyewear device 4, and by using a laser as a guide, the center and the directional axis are matched with the reference point and the reference direction.

Next, in Step S104, the coordinate synchronizing unit 601 obtains an observation route 661a (FIG. 9B) by converting the observation route 661 from the absolute coordinate system to a coordinate space with an origin set at the reference point.

Steps S101 to S104 are initial settings for using the display system 1. Accordingly, in Step S105, the observation route 661a can be superimposed and displayed on a landscape of the site on the display 41.

Then, in Step S106, the worker installs the scanner 2 according to this display of the observation route, and executes point cloud data observation at the installation point.

In this way, in the present embodiment, by using the scanner 2, an observation route that meets the required point cloud density and enables observation of the entire observation site with the minimum number of instrument installation points can be superimposed and displayed on a landscape of the site. As a result, the worker can easily perform point cloud observation without omission only by installing the scanner 2 according to the display and performing observation. In particular, in the present embodiment, the observation route is calculated in consideration of information on three-dimensional structures included in three-dimensional CAD design data of the observation site, so that not just two-dimensional but also three-dimensional observation without omission is possible, and determination by checking the structures in the height direction can be easily made.

In the present embodiment, a shortest route connecting all instrument installation points is calculated, so that point cloud observation can be particularly efficiently performed.

### Modification 1

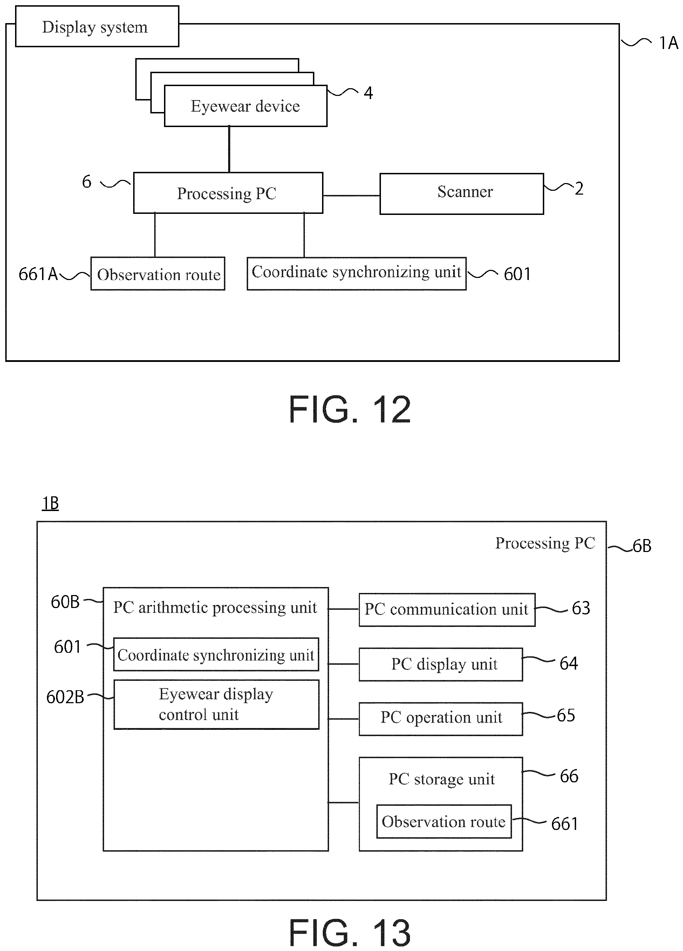

FIG. 12 is a configuration block diagram of an eyewear display system 1A according to a modification of the embodiment. The display system 1A has roughly the same configuration as that of the display system 1, but the observation route 661A to be used is not calculated by a computer simulation but predicted by machine learning.

Specifically, in three-dimensional CAD design data, an observation route predicted from current three-dimensional CAD data by using a reinforcement learning model created by performing reinforcement learning in which, on the assumption that a scanner 2 having a set distance-measuring light pulse interval, a set scanner rotation speed, and set instrument center coordinates (instrument height) has been installed at an arbitrary instrument installation point P, next instrument installation points are set so that arrangement of the points which can finally meet required point cloud density with a minimum number of instrument installation points maximizes a reward, is used as the observation route 661A.

As a reinforcement learning method, a publicly known method such as the Monte Carlo method and Q-learning method can be used.

### Modification 2

FIG. 13 is a configuration block diagram of a processing PC 6B of an eyewear display system 1B according to another modification of the embodiment. Although not illustrated in the drawing, the display system 1B has roughly the same configuration as that of the display system 1, and includes a scanner 2B, an eyewear device 4, and the processing PC 6B. Each time point cloud data observation at a certain instrument installation point is completed, the scanner 2B transmits information (observation progress information) of the observation completion at the instrument installation point to the processing PC 6B.

The processing PC 6B includes an eyewear display control unit 602B in place of the eyewear display control unit 602.

The coordinate synchronizing unit 601 is the same as in the display system 1, and synchronizes the observation route 661 with the eyewear device 4 and converts it into an observation route 661a (not illustrated).

The eyewear display control unit 602B updates the observation route 661a synchronized by the coordinate synchronizing unit 601 according to observation progress information received from the scanner 2 as described later.

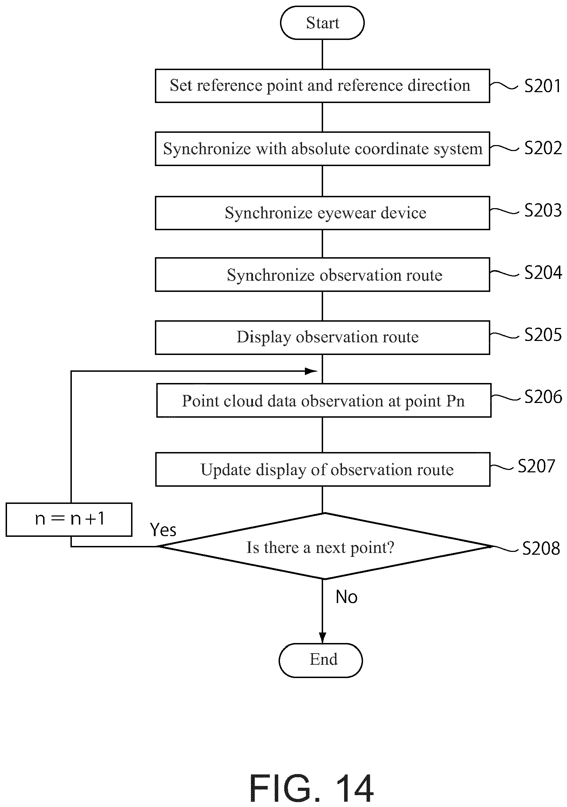

FIG. 14 is a flowchart of a point cloud observation method using the display system 1B. Steps S201 to S205 are the same as Steps S101 to S105, however, when performing point cloud observation by the scanner 2, in Step S206, the scanner 2 transmits point cloud data observation progress information at each point to the PC arithmetic processing unit 60B. Next, in Step S207, each time point cloud data observation at a certain point is completed, the eyewear display control unit 602 updates display of the observation route 661a displayed on the display 41.

Specifically, each time point cloud data observation at each point is completed, display for prompting shifting to a next instrument installation point, such as display with a change in color of a point at which point cloud observation has been completed, and flashing display of an arrow toward a next instrument installation point, is performed. Further, it is also possible that, from the scanner 2, acquired point cloud data is received together with the observation progress information, and the acquired point cloud data is displayed on the display 41. The point cloud data observation is performed while the display is updated each time the observation at each point is completed.

With this configuration, the worker can grasp an observation progress status without any special awareness, and can smoothly move to work at a next point.

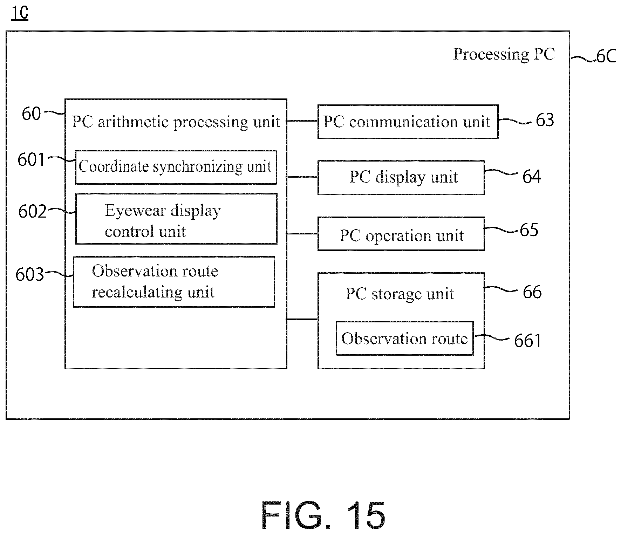

FIG. 15 is a configuration block diagram of a processing PC 6C of an eyewear display system 1C according to still another modification of the embodiment. The display system 1C has roughly the same configuration as that of the display system 1B, however, the processing PC 6C further includes an observation route recalculating unit 603.

The present modification responds to a case where the instrument installation points cannot be set in the order displayed in the observation route 661a in the observation site. When the instrument installation points cannot be set in the order in the displayed observation route 661a, the observation route recalculating unit 603 installs the scanner 2 at a different point and acquires installation information of the scanner 2, and by defining this point as a start point, recalculates the setting order of instrument installation points.

With the configuration described above, it becomes possible to respond to the case where instrument installation points cannot be set in the order in an initial observation route.

Although the information processing device and the storage device are configured as the processing PC 6 in the embodiment, as a still another modification, the information processing device and the storage device may be configured as follows.
(1) The eyewear storage unit 47 of the eyewear device 4 may be caused to function as the storage device, and the eyewear arithmetic processing unit 43 may be caused to function as the information processing device. This configuration is realized by an improvement in performance and downsizing of a storage medium and a control unit constituting the eyewear storage unit and the eyewear arithmetic processing unit. Accordingly, the configuration of the display system 1 can be simplified.
(2) A server device capable of communicating with the processing PC 6, the scanner 2, and the eyewear device 4 is further provided, and the server device is configured to serve as the storage device and the information processing device. With this configuration, the burden of processing on the processing PC 6 can be reduced, and a processing time can be significantly shortened.

Accordingly, the burden on the PC storage unit 66 of the processing PC 6 can be reduced.

Although a preferred embodiment and the modifications thereof according to the present invention have been described above, the embodiment and the modifications described above are examples of the present invention, and the embodiment and the modifications can be combined with other embodiments and modifications based on the knowledge of a person skilled in the art, and such combined embodiments are also included in the scope of the present invention.

### REFERENCE SIGNS LIST

- 1:: Eyewear display system
- 1A:: Eyewear display system
- 1B:: Eyewear display system
- 1C:: Eyewear display system
- 2:: Scanner
- 41:: Display
- 42:: Control unit
- 261:: Point cloud data acquiring unit
- 601:: Coordinate synchronizing unit
- 661a:: Observation route
- 6:: Processing PC
- 6B:: Processing PC
- 6C:: Processing PC

## Claims

1. An eyewear display system (1) comprising:
a scanner (2) including a measuring unit (21) configured to irradiate pulsed distance-measuring light and acquire three-dimensional coordinates of an irradiation point by measuring a distance and an angle to the irradiation point, and a point cloud data acquiring unit (261) configured to acquire point cloud data as observation data by rotationally irradiating distance-measuring light in the vertical direction and the horizontal direction by the measuring unit (21) and
an eyewear device (4) including a display (41), a relative position detection sensor (45) configured to detect a position of the device (4), and a relative direction detection sensor (46) configured to detect a direction of the device (4);
**characterized by**
a storage device (66) configured to store an observation route (661) calculated in consideration of three-dimensional CAD design data of an observation site and instrument information of the scanner (2); and
an information processing device (6) including a coordinate synchronizing unit (601) configured to synchronize information on a position and a direction of the eyewear device (4) and a coordinate space of the observation route (661), and a display control unit (602) configured to control display of the observation route (661) on the display (41), wherein
the scanner (2), the eyewear device (4), the storage device (66), and the information processing device (6) are capable of inputting and outputting information to each other, and the eyewear device (4) superimposes and displays the observation route (661) on a landscape of the site.

2. The eyewear display system (1) according to Claim 1, wherein
the observation route (661) is calculated to enable acquisition of point cloud data at required point cloud density by a minimum number of instrument installation points in the entire observation site in consideration of the instrument information of the scanner (2) and a three-dimensional structure in the three-dimensional CAD design data, and
the instrument information of the scanner (2) includes coordinates of an instrument center of the scanner (2), pulse interval setting of the distance-measuring light, and rotation speed setting of the scanner (2).

3. The eyewear display system (1) according to Claim 1 or 2, wherein the observation route (661) is calculated to be a shortest route connecting all instrument installation points in the observation site.

4. The eyewear display system (1) according to any of Claims 1 to 3, wherein the eyewear device (4) is configured to update display of the observation route (661) according to observation progress.

5. The eyewear display system (1) according to any of Claims 1 to 4, wherein the information processing device is configured to recalculate the order of the instrument installation points in the observation route (661) when point cloud observation by the scanner (2) deviates from the observation route (661).

6. An eyewear display method performed by an information processing device (6) capable of inputting and outputting information among:
a scanner (2) including a measuring unit (21) configured to irradiate pulsed distance-measuring light and acquire three-dimensional coordinates of an irradiation point by measuring a distance and an angle to the irradiation point, and a point cloud data acquiring unit configured to acquire point cloud data as observation data by rotationally irradiating distance-measuring light in the vertical direction and the horizontal direction by the measuring unit,
an eyewear device (4) including a display (41), a relative position detection sensor (45) configured to detect a position of the device, and a relative direction detection sensor (46) configured to detect a direction of the device (4), and a storage device (66) configured to store an observation route (661) calculated in consideration of three-dimensional CAD design data of an observation site and instrument information of the scanner (2),
wherein the method comprises the steps of:
synchronizing information on a position and a direction of the eyewear device (4) and a coordinate space of the observation route (661); and
controlling display of the observation route (661) on the display such that eyewear device (4) superimposes and displays the observation route (661) on a landscape of the site.

7. A program for causing the information processing device (6), which is a computer, to carry out the eyewear display method according to claim 6.

## Patentansprüche

1. Brillenanzeigesystem (1), das aufweist:
einen Scanner (2), der eine Messeinheit (21) enthält, die dazu ausgebildet ist, gepulstes Entfernungsmesslicht auszustrahlen und dreidimensionale Koordination eines Ausstrahlungspunkts durch Messen einer Entfernung und eines Winkels zu dem Ausstrahlungspunkt zu erfassen, und der eine Punktwolkendaten-Erfassungseinheit (261) enthält, die dazu ausgebildet ist, Punktwolkendaten als Beobachtungsdaten zu erfassen, indem Entfernungsmesslicht rotatorisch in der vertikalen Richtung und der horizontalen Richtung von der Messeinheit (21) ausgestrahlt wird, und
eine Brillenvorrichtung (4), die ein Display (41), einen relativen Positionsdetektionssensor (45), der dazu ausgebildet ist, eine Position der Vorrichtung (4) zu detektieren, und einen relativen Richtungsdetektionssensor (46) enthält, der dazu ausgebildet ist, eine Richtung der Vorrichtung (4) zu detektieren;
**gekennzeichnet durch**
eine Speichervorrichtung (66), die dazu ausgebildet ist, eine Beobachtungsroute (661) zu speichern, die unter Berücksichtigung der dreidimensionalen CAD-Konstruktionsdaten eines Beobachtungsortes und Instrumenteninformationen des Scanners (2) berechnet wird; und
eine Informationsverarbeitungsvorrichtung (6), die eine Koordinatensynchronisierungseinheit (601) aufweist, die dazu ausgebildet ist, Informationen zu einer Position und einer Richtung der Brillenvorrichtung (4) und einen Koordinatenraum der Beobachtungsroute (661) zu synchronisieren, und eine Anzeigesteuereinheit (602) aufweist, die dazu ausgebildet ist, die Anzeige der Beobachtungsroute (661) auf dem Display (41) zu steuern, wobei
der Scanner (2), die Brillenvorrichtung (4), die Speichervorrichtung (66) und die Informationsverarbeitungsvorrichtung (6) zur gegenseitige Eingabe und Ausgabe von Informationen in der Lage sind, und die Brillenvorrichtung (4) die Beobachtungsroute (661) auf einer Landschaft des Ortes überlagert und anzeigt.

2. Brillenanzeigesystem (1) nach Anspruch 1, wobei
die Beobachtungsroute (661) berechnet wird, um die Erfassung von Punktwolkendaten mit einer erforderlichen Punktwolkendichte durch eine minimale Anzahl von Instrumenteninstallationspunkten im gesamten Beobachtungsort unter Berücksichtigung der Instrumenteninformationen des Scanners (2) und einer dreidimensionalen Struktur in den dreidimensionalen CAD-Konstruktionsdaten zu ermöglichen, und
die Instrumenteninformationen des Scanners (2) Koordinaten einer Instrumentenmitte des Scanners (2), Pulsintervalleinstellung des Entfernungsmessungslichts, und Drehgeschwindigkeitseinstellung des Scanners (2) enthalten.

3. Brillenanzeigesystem (1) nach Anspruch 1 oder 2, wobei die Beobachtungsroute (661) so berechnet wird, dass sie ein kürzeste Route ist, die sämtliche Instrumenteninstallationspunkte in dem Beobachtungsort verbindet.

4. Brillenanzeigesystem (1) nach einem der Ansprüche 1 bis 3, wobei die Brillenvorrichtung (4) dazu ausgebildet ist, die Anzeige der Beobachtungsroute (661) gemäß dem Beobachtungsfortschritt zu aktualisieren.

5. Brillenanzeigesystem (1) nach einem der Ansprüche 1 bis 4, wobei die Informationsverarbeitungsvorrichtung dazu ausgebildet ist, die Reihenfolge der Instrumenteninstallationspunkte in der Beobachtungsroute (661) neu zu berechnen, wenn die Punktwolkenbeobachtung durch den Scanner (2) von der Beobachtungsroute (661) abweicht.

6. Brillenanzeigeverfahren, das von einer Informationsverarbeitungsvorrichtung (6) durchgeführt wird, die in der Lage ist, Informationen zwischen Folgendem einzugeben und auszugeben:
einem Scanner (2), der eine Messeinheit (21) enthält, die dazu ausgebildet ist, gepulstes Entfernungsmesslicht auszustrahlen und dreidimensionale Koordination eines Ausstrahlungspunkts durch Messen einer Entfernung und eines Winkels zu dem Ausstrahlungspunkt zu erfassen, und der eine Punktwolkendatenerfassungseinheit enthält, die dazu ausgebildet ist, Punktwolkendaten als Punktbeobachtungsdaten zu erfassen, indem Entfernungsmesslicht rotatorisch in der vertikalen Richtung und der horizontalen Richtung von der Messeinheit ausgestrahlt wird, und
einer Brillenvorrichtung (4), die ein Display (41), einen relativen Positionsdetektionssensor (45), der dazu ausgebildet ist eine Position der Vorrichtung (4) zu detektieren, und einen relativen Richtungsdetektionssensor (46) enthält, der dazu ausgebildet ist, eine Richtung der Vorrichtung (4) zu detektieren, und
eine Speichervorrichtung (66), die dazu ausgebildet ist, eine Beobachtungsroute (661) zu speichern, die unter Berücksichtigung der dreidimensionalen CAD-Konstruktionsdaten eines Beobachtungsortes und Instrumenteninformationen des Scanners (2) berechnet wird,
wobei das Verfahren die folgenden Schritte umfasst:
Synchronisieren von Informationen zu einer Position und einer Richtung der Brillenvorrichtung (4) und einen Koordinatenraum der Beobachtungsroute (661); und
Steuern der Anzeige der Beobachtungsroute (661) auf dem Display (41), so dass die Brillenvorrichtung (4) die Beobachtungsroute (661) auf einer Landschaft des Standorts überlagert und anzeigt.

7. Programm, um zu bewirken, dass die Informationsverarbeitungsvorrichtung (6), die ein Computer ist, das Brillenanzeigeverfahren nach Anspruch 6 durchführt.

## Revendications

1. Système d'affichage de lunettes (1) comprenant :
un dispositif de balayage (2) incluant une unité de mesure (21) configurée pour irradier une lumière de mesure de distance pulsée et acquérir des coordonnées tridimensionnelles d'un point d'irradiation en mesurant une distance et un angle par rapport au point d'irradiation, et une unité d'acquisition de données de nuage de points (261) configurée pour acquérir des données de nuage de points en tant que données d'observation en irradiant de manière rotative une lumière de mesure de distance dans la direction verticale et la direction horizontale par l'intermédiaire de l'unité de mesure (21) et
un dispositif de lunettes (4) incluant un dispositif d'affichage (41), un capteur de détection de position relative (45) configuré pour détecter une position du dispositif (4), et un capteur de détection de direction relative (46) configuré pour détecter une direction du dispositif de lunettes (4) ;
**caractérisé par** :
un dispositif de stockage (66) configuré pour stocker un trajet d'observation (661) calculé en considération de données de conception CAO tridimensionnelle d'un site d'observation et d'informations d'instrument du dispositif de balayage (2) ; et
un dispositif de traitement d'informations (6) incluant une unité de synchronisation de coordonnées (601) configurée pour synchroniser des informations sur une position et une direction du dispositif de lunettes (4) et un espace de coordonnées du trajet d'observation (661), et une unité de commande d'affichage (602) configurée pour commander un affichage du trajet d'observation (661) sur le dispositif d'affichage (41),
le dispositif de balayage (2), le dispositif de lunettes (4), le dispositif de stockage (66), et le dispositif de traitement d'informations (6) étant capables d'entrer et de délivrer en sortie des informations les uns aux autres, et le dispositif de lunettes (4) superposant et affichant le trajet d'observation (661) sur un paysage du site.

2. Système d'affichage de lunettes (1) selon la revendication 1, le trajet d'observation (661) étant calculé pour permettre l'acquisition de données de nuage de points à la densité de nuage de points requise par un nombre minimum de points d'installation d'instrument dans l'ensemble du site d'observation en tenant compte des informations d'instrument du dispositif de balayage (2) et d'une structure tridimensionnelle dans les données de conception CAO tridimensionnelles, et
les informations d'instrument du dispositif de balayage (2) incluant des coordonnées d'un centre d'instrument du dispositif de balayage (2), un réglage d'intervalle d'impulsion de la lumière de mesure de distance, et un réglage de vitesse de rotation du dispositif de balayage (2).

3. Système d'affichage de lunettes (1) selon la revendication 1 ou 2, le trajet d'observation (661) étant calculé pour être un trajet le plus court reliant tous les points d'installation d'instrument dans le site d'observation.

4. Système d'affichage de lunettes (1) selon l'une quelconque des revendications 1 à 3, le dispositif de lunettes (4) étant configuré pour mettre à jour l'affichage du trajet d'observation (661) en fonction de la progression de l'observation.

5. Système d'affichage de lunettes (1) selon l'une quelconque des revendications 1 à 4, le dispositif de traitement d'informations étant configuré pour recalculer l'ordre des points d'installation d'instrument dans le trajet d'observation (661) lorsque l'observation de nuage de points par le dispositif de balayage (2) s'écarte du trajet d'observation (661).

6. Procédé d'affichage de lunettes exécuté par un dispositif de traitement d'informations (6) capable d'entrer et de délivrer en sortie des informations parmi :
un dispositif de balayage (2) incluant une unité de mesure (21) configurée pour irradier une lumière de mesure de distance pulsée et acquérir des coordonnées tridimensionnelles d'un point d'irradiation en mesurant une distance et un angle par rapport au point d'irradiation, et une unité d'acquisition de données de nuage de points configurée pour acquérir des données de nuage de points en tant que données d'observation en irradiant de manière rotative une lumière de mesure de distance dans la direction verticale et la direction horizontale par l'intermédiaire de l'unité de mesure,
un dispositif de lunettes (4) incluant un dispositif d'affichage (41), un capteur de détection de position relative (45) configuré pour détecter une position du dispositif, et un capteur de détection de direction relative (46) configuré pour détecter une direction du dispositif de lunettes (4), et
un dispositif de stockage (66) configuré pour stocker un trajet d'observation (661) calculé en considération de données de conception CAO tridimensionnelle d'un site d'observation et d'informations d'instrument du dispositif de balayage (2),
le procédé comprenant les étapes consistant à :
synchroniser des informations sur une position et une direction du dispositif de lunetterie (4) et un espace de coordonnées du trajet d'observation (661) ; et
commander un affichage du trajet d'observation (661) sur le dispositif d'affichage de sorte que le dispositif de lunettes (4) superpose et affiche le trajet d'observation (661) sur un paysage du site.

7. Programme pour amener le dispositif de traitement d'informations (6), qui est un ordinateur, à mettre en oeuvre le procédé d'affichage de lunettes selon la revendication 6.
